Europäisches Patentamt

European Patent Office

Office européen des brevets

(19)

(11) Veröffentlichungsnummer: **0 013 985**
**B1**

(12) EUROPÄISCHE PATENTSCHRIFT

(45) Veröffentlichungstag der Patentschrift:
02.09.81

(51) Int. Cl.³: **C 30 B 15/06, C 30 B 15/02**

(21) Anmeldenummer: 80100358.3

(22) Anmeldetag: 24.01.80

(54) **Verfahren zur Herstellung grobkristalliner vorzugsorientierter Siliciumfolien.**

(30) Priorität: 26.01.79 DE 2903061

(43) Veröffentlichungstag der Anmeldung:
06.08.80 Patentblatt 80/16

(45) Bekanntmachung des Hinweises auf die Patenterteilung:
02.09.81 Patentblatt 81/35

(84) Benannte Vertragsstaaten:
**BE DE FR GB IT NL**

(56) Entgegenhaltungen:
**DE-B-1 251 272**
**US-A-3 031 275**
**US-A-3 759 671**
**US-A-4 036 595**

(73) Patentinhaber: **HELIOTRONIC Forschungs- und Entwicklungsgesellschaft für Solarzellen-Grundstoffe mbH, Johannes-Hess-Strasse 24, D-8263 Burghausen (DE)**

(72) Erfinder: **Ast, Gerhard, Goethestrasse 12, D-8261 Emmerting (DE)**
Erfinder: **Dietl, Josef, Dr. Dipl.-Phys., Am Bärenbach 17, D-8262 Neuötting (DE)**
Erfinder: **Helmreich, Dieter, Dr. Dipl.-Ing., Robert-Koch-Strasse 185, D-8263 Burghausen (DE)**
Erfinder: **Miller, Hans-Dieter, Dr. Dipl.-Ing., Fährmannweg 6, D-8261 Stammham (DE)**
Erfinder: **Sirtl, Erhard, Prof. Dr. Dipl.-Chem., Kiefernweg 11, D-8261 Marktl/Inn (DE)**

## Verfahren zur Herstellung grobkristalliner vorzugsorientierter Siliciumfolien

Gegenstand der Erfindung ist ein Verfahren zur Herstellung grobkristalliner vorzugsorientierter Siliciumfolien mit einer Dicke von 0,2 bis 2 mm als Grundmaterial für Solarzellen durch in Kontakt bringen einer Siliciumschmelze mit einer schmelzflüssigen, mit Silicium nicht mischbaren, niedriger schmelzenden nicht elementaren Zweitphase und nachfolgendem Erstarrenlassen.

Solarzellen, wie sie in der Raumfahrt bislang als Stromerzeuger eingesetzt werden, sind für eine breite terrestrische Anwendung viel zu teuer. Derartige Solarzellen werden aus einkristallinem Silicium gefertigt, welches nach einem der beiden klassischen Verfahren, dem Tiegelziehen nach Czochralski oder dem tiegelfreien Zonenschmelzen, hergestellt wird. Bei der Aufarbeitung der nach diesen Verfahren erhaltenen Siliciumstäbe gehen allein schon mindestens 50% des Materials verloren, so daß diese Techniken für die Massenproduktion von Solarzellengrundmaterial von vorneherein auszuschließen sind.

Zahlreiche Verfahren sind in der Zwischenzeit bekannt geworden, welche sich die Herstellung von billigem, einkristallinem Siliciummaterial zum Ziel gesetzt haben. Den meisten dieser Verfahren ist dabei gemeinsam, daß versucht wird, Silicium direkt in Bandform zu erhalten, um auf diese Art den Kosten und Material verbrauchenden Sägeschritt einsparen zu können. Dies erfolgt beispielsweise dadurch, daß aus einem polykristallinen Siliciumvorratsstab über eine formgebende Düse ein einkristallines Siliciumband gezogen wird. Nach dem EFG-Verfahren wird z. B. über einen, in eine Siliciumschmelze eintauchenden formgebenden Kapillarkörper aus Kohlenstoff monokristallines Silicium in Bandform nach oben abgezogen. Nach dem Verfahren von Bleil wird Silicium in einem Schmelztiegel aufgeschmolzen und seitwärts mit einem Keimkristall ein Siliciumband unter der Einwirkung eines Temperaturgradienten abgezogen, wobei die konstante Schmelzhöhe im Tiegel durch ein System von in die Schmelze eintauchenden Verdrängungskörpern gewährleistet wird. Nach dem Verfahren von Shockley wird schließlich bandförmiges Silicium dadurch erhalten, daß ein polykristalliner Vorratsstab auf flüssiges Blei oder flüssige Salze (US-A-303/275) aufgeschmolzen und hier von unter der Einwirkung eines Temperaturgradienten mit Hilfe eines Keimkristalls horizontal als Band abgezogen wird. Die Wirtschaftlichkeit der genannten Verfahren wird allerdings durch die geringen Ziehgeschwindigkeiten, die in der Größenordnung von wenigen Zentimetern in der Minute liegen, begrenzt. Beim letztgenannten Verfahren kommt noch erschwerend hinzu, daß das als Substratfläche bevorzugt eingesetzte Blei außerordentlich rein sein muß, damit es nicht zu einer Verunreinigung des darauf aufgeschmolzenen und wiedererstarrten Siliciums kommt. Ein weiterer Nachteil liegt in dem hohen Dampfdruck des Bleis, welcher dazu führt, daß sich am kühlen Ende der Apparatur, an welcher das wiedererstarrte Silicium abgezogen wird, es unvermeidlich zu Abscheidungen von Blei auf dem Siliciumband kommt. Eine umfassende Darstellung dieser und ähnlicher Verfahren findet sich in dem Artikel von Jean-Jacques Brissot »Silicium pour photopiles solaires«, Akta Electronica, 20, 2, 1977, Seite 101 bis 116.

Der Erfindung lag daher die Aufgabe zugrunde, ein Verfahren zu finden, nach welchen sich Siliciumfolien, welche als Grundmaterial für die Herstellung von Solarzellen geeignet sind, mit hohen Ziehgeschwindigkeiten preiswert herstellen lassen.

Gelöst wird diese Aufgabe durch ein Verfahren, welches dadurch gekennzeichnet ist, daß aus einem flüssigen Silicium und eine Silicium benetzende Gleitschmelze enthaltendem Ziehgefäß durch Unterkühlung mindestens einer über die Schmelzoberfläche herausragenden, eine Ziehrampe bildende Gefäßwandung auf 1320 bis 1415° C ein auf dieser Fläche auskristallisierender Siliciumfilm kontinuierlich abgezogen wird.

Die durchschnittlichen Ziehgeschwindigkeiten variieren anlagenspezifisch zwischen ca. 1 bis 200 cm/Minute. Die durchschnittliche Korngröße derartiger grobkristalliner Siliciumfolien soll dabei mindestens etwa 1 mm betragen. Vorzugsorientiert bedeutet hierbei, daß bestimmte Kristallisationsrichtungen über dem statistischen Mittel liegen sollen, insbesondere, daß beispielsweise die Kristallite, die in [111]-Richtungen wachsen, das statistische Mittel um etwa das Drei- bis Fünffache oder mehr übertreffen.

Gleitschmelzen, wie sie in dem Verfahren eingesetzt werden, müssen einen Schmelzpunkt aufweisen, der unterhalb dem des Siliciums liegt, also einen Schmelzpunkt von etwa 800 bis 1400° C, vorzugsweise etwa 1100 bis 1200° C. Allgemein werden für derartige Gleitschmelzen Verbindungen bevorzugt, deren Dampfdruck im Temperaturbereich von etwa 1400 bis 1500° C möglichst niedrig ist. Auch sollten derartige Schmelzen keine Elemente oder Verunreinigungen enthalten bzw. an Silicium abgeben, die als Lebensdauer-Killer für die Minoritätenträger im Silicium angesehen werden können. Auch sollte die Löslichkeit der die Gleitschmelze aufbauenden Komponenten und ihre Verunreinigungen in der Siliciumschmelze möglichst gering sein, d. h. die Gleitschmelze sollte mit Silicium nicht mischbar sein, es sollte also zwischen beiden Systemen sich eine Phasengrenze ausbilden. Andererseits ist es aber wiederum erforderlich, daß das Silicium von der Gleitschmelze benetzt wird. Eine geringe Grenzflächenspannung zwischen Gleitschmelze und flüssigem Silicium ist erforderlich, um eine möglichst gute Ausbreitung des Siliciums zu einem Siliciumfilm zu erzielen oder beizubehalten, wenn die Formgebung des Siliciumfilmes durch andere Maßnahmen, beispielsweise eine spezielle Form des Überlaufs, vorgegeben wird. Die hohe Oberflächenspannung einer Siliciumschmelze (725 dyn/cm) im Gegensatz zu einsetzbaren Gleitschmelzen (etwa 200 bis 350 dyn/cm) ist die Ursache dafür, daß sich das schmelzflüssige Silicium sehr schnell mit einem dünnen Film dieser Gleitschmelze überzieht.

Besonders geeignet als Gleitschmelzen sind Schmelzen aus Erdalkalifluoriden im Gemisch mit 10 bis 90 Mol-% Erdalkalisilikaten, wobei die Zusammensetzung innerhalb der angegebenen Grenzen so beschaffen sein muß, daß der Schmelzpunkt unter dem des Siliciums liegt. Eingesetzt werden können so die Fluoride und Silikate der Erdalkalielemente Magnesium, Kalzium, Strontium und Barium, wobei allein schon wegen der geringen Kosten Kalzium und Magnesiumverbindungen bevorzugt werden. Die Erdalkalifluoride können dabei allein, im Gemisch mit weiteren Erdalkalifluoriden oder im Gemisch mit Erdalkalisilikaten in der oben angegebenen Menge eingesetzt werden. Geeignet sind beispielsweise Mischungen aus Magnesiumfluorid mit Kalziumsilikat oder Magnesiumfluorid mit Magnesiumsilikat, Mischungen aus Kalziumfluorid mit Magnesiumsilikat sowie vorzugsweise Mischungen aus Kalziumfluorid und Kalziumsilikat, dies insbesondere aufgrund des gegenüber Magnesiumfluorid erheblich niedrigeren Dampfdruckes des Kalziumfluorids. Geeignete Gleitschmelzen, deren Schmelzpunkt in dem bevorzugten Bereich von etwa 1100 bis 1200° liegt, sind beispielsweise Mischungen aus Kalziumsilikat mit etwa 30 bis 70 Mol-% Kalziumfluorid. Neben den Erdalkalifluoriden und Erdalkalisilikaten lassen sich aber auch andere Substanzen als Gleitschmelzen einsetzen, beispielsweise Sulfide von Übergangsmetallen, wie insbesondere Mangan- oder Eisensulfid, die gegenüber Silicium eine wesentlich höhere Dichte aufweisen. Als günstig hat es sich auch erwiesen, den Gleitschmelzen, insbesondere im Falle von Erdalkalifluoriden und Erdalkalisilikaten Schwefelverbindungen, wie beispielsweise Sulfide, insbesondere solche der II. und III. Hauptgruppe des periodischen Systems der Elemente, wie Kalzium- oder Aluminiumsulfid zuzusetzen, da durch derartige Zusätze die Grenzflächenspannung zwischen Silicium und der Gleitschmelze herabgesetzt werden kann, so daß das schmelzflüssige Silicium leichter zu einem dünnen Film auseinandergezogen werden kann. Aufgrund der herabgesetzten Grenzflächenspannung überzieht sich die gesamte Oberfläche der Siliciumschmelze mit einer dünnen Schicht Gleitschmelze, wodurch ein hervorragender Schutz gegen Oxidation des Siliciums erzielt wird. Durch die Art und Menge der der Gleitschmelze zugesetzten sulfidischen Verbindungen läßt sich auch die Dicke derartiger Schutzschichten beeinflussen. Wird dafür Sorge getragen, daß sämtliche im Verfahren eingesetzten, mit schmelzflüssigem Silicium befüllten Gefäße oder Vorrichtungsbestandteile mit Gleitschmelze überzogen sind, so kann der Prozeß auch unter Zutritt von Luft durchgeführt werden. Der hierdurch eingesparte apparative Aufwand kann dabei zu einer wesentlichen Verbilligung des Verfahrensproduktes führen. In den Fällen, in denen die Oberflächenspannung des Siliciums durch Zusätze in der Gleitschmelze so weit herabgesetzt ist, daß sich der gesamte Siliciumfilm mit einer dünnen Schicht dieser Gleitschmelze überzieht, kann diese dünne Schicht auf der erstarrten Siliciumfolie verbleiben und als solche bei gegebenenfalls nachfolgenden Temperaturprozessen als Gettersubstanz für schnell diffundierende Verunreinigungen wirken. Andererseits kann sie aber auch leicht in einem nachfolgenden Ätzgang entfernt werden: beispielsweise durch Wasserstoff oder insbesondere gasförmigen Chlorwasserstoff oder Flußsäure.

Die Erfindung wird nachfolgend anhand der Abbildungen beispielshaft erläutert:

Fig. 1 zeigt schematisch eine Vorrichtung im Längsschnitt, bei welcher die Siliciumfolien zur Seite abgezogen werden.

Fig. 2 zeigt schematisch eine Vorrichtung im Längsschnitt, bei welcher die Siliciumfolien nach oben abgezogen werden.

Fig. 3 zeigt schematisch die in Fig. 2 im Längsschnitt dargestellte Vorrichtung in der Aufsicht.

In einem Rezipienten 1 aus beispielsweise Edelstahl oder silberplattiertem Stahl, welcher zweckmäßig doppelwandig zur Aufnahme eines Kühlmediums, wie beispielsweise Wasser, ausgeführt wird und welcher über eine oder mehrere Abdeckungen 2 mit Silicium beschickt werden kann, ist ein Schmelztiegel 3 über eine Tiegelwelle 4 vertikal verschiebbar in einer Heizvorrichtung 5, beispielsweise einem über eine Widerstandsheizung beheizbaren Graphitrohr angeordnet. Dieser große Tiegel 3 dient als Vorratstiegel und kann chargenweise bei Entleerung gegen einen jeweils frisch befüllten ausgetauscht werden oder über eine entsprechende Zusatzvorrichtung mit schmelzflüssigem Silicium neu befüllt werden. Die letztere Ausführungsform bietet sich insbesondere dann an, wenn das erfindungsgemäße Verfahren mit einem Reinigungsverfahren für Silicium, bei welchem dieses schmelzflüssig anfällt, kombiniert wird.

Als Schmelztiegel 3 lassen sich beispielsweise solche aus Glaskohlenstoff, aus siliciumcarbid- bzw. siliciumnitridbeschichtetem Graphit oder auch mit einer Schutzschmelze imprägniertem Graphit einsetzen. Das in dem Schmelztiegel 3 befindliche Silicium wird beispielsweise über ein Kapillarsystem 6 nach dem Heber-Prinzip in eine Kristallisationswanne 7 überführt.

Statt vermittels eines Kapillarkörpers kann der Überlauf des Siliciums aus dem Vorratsgefäß in die Kristallisationswanne auch durch einen in das Vorratsgefäß eingeführten Verdrängungskörper erfolgen oder durch Überpressen von Silicium unter der Einwirkung eines Gasdruckes auf die Siliciumschmelze bei einem geschlossen ausgebildeten Vorratsgefäß mit einer in die Kristallisationswanne einmündenden Ausflußöffnung.

Als Werkstoffe für das Kapillarsystem 6 kommen Materialien in Frage, die von der Siliciumschmelze benetzt werden. Geeignet sind beispielsweise Siliciumcarbid, siliciumcarbidbeschichteter oder siliciumimprägnierter Graphit. Die Kapillaren des Überlaufs 6 werden dabei beispielsweise aus konzentrischen Rohren gebildet oder aus einem Massivkörper, welcher an der Außenseite über einen oder mehrere Einfräsungen verfügt, welche in Richtung des gewünschten Siliciumflusses angeordnet sind. Die Höhe des eingesetzten Überlaufs 6 ist dabei auf den Kapillardurchmesser abgestimmt. Für die Steighöhen von Silicium in Siliciumcarbid bei einem Kapillardurchmesser von 1,5 mm wurde beispielsweise eine Steighöhe von 20 mm ermittelt und in siliciumimprägniertem Graphit bei einem Kapillardurchmesser von 1 mm eine Steighöhe von 49 mm sowie bei einem Kapillardurchmesser von 0,5 mm eine solche von 97 mm.

Vermittels der Aufhängung 8 kann dieser Siliciumüberlauf 6 in das Schmelzgefäß 3 und die Kristallisationswanne 7 eingeführt bzw. aus diesen wieder herausgezogen werden. Der Niveauunterschied zwischen den Siliciumschmelzen im Tiegel 3 sowie in der Kristallisationswanne 7 kann über die Tiegelwelle 4 verändert werden. Hierdurch ist eine Regelmöglichkeit der Durchflußmenge an Silicium vom Schmelzgefäß 3 in die Kristallisationswanne 7 gegeben und somit eine Einstellung der Schmelzhöhe in der Kristallisationswanne 7. Über die Niveauregler 9 und 10, welche die Siliciumschmelzhöhen im Schmelzgefäß 3 bzw. in der Kristallisationswanne 7 optisch-elektrisch vermittels Ultraschall oder anderer bekannter Methoden ermitteln, wird nach Vergleich der gemessenen Daten mit den entsprechenden Sollwerten zweckmäßig über einen Rechner die vertikale Bewegung des Kapillarkörpers 6 gesteuert. Eine Temperaturmeßstelle 11 am unteren Ende des in die Kristallisationswanne 7 einmündenden Überlaufs 6 erfaßt die Regelgröße für eine Zusatzheizung 12, beispielsweise eine Strahlungsheizung, welche oberhalb des Überlaufs 6 angeordnet ist und durch welche gewährleistet werden soll, daß das Kapillarsystem bzw. der Heber immer eine konstante Temperatur oberhalb des Schmelzpunktes von Silicium aufweisen. Die Temperaturführung in der vorteilhaft aus beispielsweise Graphit hergestellten Kristallisationswanne 7 erfolgt durch ein System mehrerer Heizkörper im Verbund mit einer entsprechenden Kühleinrichtung. Zweckmäßig wird beispielsweise durch einen Flächenheizer 13 unterhalb der Kristallisationswanne 7 diese so weit erhitzt, daß die darin befindliche Gleitschmelze 14 bzw. die überstehende Siliciumschmelze in flüssigem Zustand gehalten wird. Die Temperaturmessung erfolgt dabei durch ein Thermoelement 15 zweckmäßig in der Wandung der Kristallisationswanne 7. Um ein Erstarren des Siliciums von der Oberseite her zu verhindern, erweist es sich außerdem als zweckmäßig, die Siliciumschmelze von der Oberseite her durch eine weitere Heizeinrichtung, beispielsweise eine Strahlungsheizung 16, beispielsweise in der Ausführung einer gekrümmten widerstandsbeheizten Graphitplatte, über den Schmelzpunkt des Siliciums hinaus zu erwärmen. Durch ein Kühlsystem 17, beispielsweise ein wasserdurchströmtes Rohrsystem, wird die Kühlrampe 18 auf eine Temperatur gekühlt, welche es erlaubt, das flüssige Silicium, welches in der Kristallisationswanne 7 eine Temperatur aufweist, die etwa 5 bis 10° über seinem Schmelzpunkt liegt, im unmittelbaren Kontakt mit dieser Kühlrampe auf eine Temperatur von etwa 5 bis 100°, vorzugsweise 10 bis 50°, unter seinen Schmelzpunkt abzukühlen und hierdurch zusammenhängend zum Erstarren zu bringen.

Die Regelung der Temperatur an der Kühlrampe 18 erfolgt dabei zweckmäßig nicht über die Kühlung 17, sondern über einen zusätzlichen Heizer 19, welcher an der Unterseite der Kühlrampe 18 angeordnet ist und insbesondere bei Beginn der Kristallisation von Bedeutung ist. Die Temperatur wird dabei über ein in der Wandung der Ziehrampe 18 eingeführtes Thermoelement 20 bestimmt.

Während der Folienherstellung wird an der Kühlrampe 18 die Kristallisationswärme des erstarrenden Siliciums frei. Die Kühlung wird über das entsprechende System 17 daher so eingestellt, daß diese zusätzliche Wärme ständig abgeführt werden kann. Soll nunmehr die Temperaturführung aber nicht über die Kühlung 17 geregelt werden, so bedarf es eines zusätzlichen Heizers 19, um insbesondere bei Beginn der Folienherstellung die später als freiwerdende Kristallisationswärme wirksame Wärmemenge der Kühlrampe 18 zuzuführen, um eine gleichmäßige Unterkühlung an der Kühlrampe 18 über den gesamten Prozeß zu gewährleisten. Vorteilhaft werden demnach während des Folienziehens die Heizer 13, 16 sowie die Kühlung 17 auf einen konstanten Wert eingestellt und der Temperaturverlauf längs der Kühlrampe 18 durch Einstellung der Heizung 19 feingeregelt. Die dabei über die Temperaturmeßstellen 20, 15 und 11 erhaltenen Werte werden zweckmäßig in einem Rechner mit vorgegebenen Sollwerten verglichen und hieraus die Regelwerte für die Heizung 19 und ggf. auch die Heizung 12 bestimmt.

Um die Siliciumfolie herauszuziehen, wird über einen vermittels einer Kurbelwelle 21 bewegbaren Wagen 22 ein Impfbügel 23 an der Kühlrampe 18 entlang in die Siliciumschmelze abgesenkt. Gleichzeitig wird durch Einstellung der Temperatur längs der Kühlrampe 18 gewährleistet, daß sich die von der Kühlrampe 18 lediglich durch einen dünnen Gleitschmelzfilm getrennte Oberflächenschicht des schmelzflüssigen Siliciums unter seinen Schmelzpunkt abgekühlt und an dem eingetauchten Impfbügel 23 erstarrend anwächst.

Eine gute Benetzung der Kühlrampe 18 durch die Gleitschmelze 14 läßt sich dadurch sicherstellen, daß zweckmäßig zumindest dieser Teil des Kristallisationsgefäßes 7 aus hochverdichtetem Graphit, der an der Oberfläche siliciumcarbidbeschichtet ist, verwendet wird. Diese oberflächliche Siliciumcarbidbeschichtung kann zwar während des Ziehprozesses durch Reaktion des Kohlenstoffs mit Silicium erfolgen, zweckmäßig wird die Kühlrampe 18 aber vorher siliciert, carbonisiert oder mit einer Siliciumnitridschicht versehen. Die Gleitschmelze 14 dient als Gleitmittel für die an dem Siliciumbügel 23 anhaftende, durch entsprechende Ziehgeschwindigkeiten auf eine Dicke von etwa 0,2 bis 2 mm begrenzte Siliciumfolie 24. Die Funktion dieser Gleitschmelze 14 liegt dabei nicht allein in ihrer Wirkung als Gleitmittel für die abzuziehende Siliciumfolie 24, sondern wirkt sich insbesondere dadurch günstig aus, daß sie naturgemäß keine Kristallisationskeime für Silicium vorgegeben enthält. Hierdurch wird das Wachstum des erstarrenden Siliciums hinsichtlich der energieärmsten und zugleich kinetisch begünstigten (111)-Kristallisationsebene gedrängt. Dies führt zur schnellen Vernetzung der beim Kristallisationsbeginn sich ausbildenden richtungsbegünstigten Keime, wodurch gewährleistet wird, daß das Wachstum senkrecht zur Kühlrampe 18 wesentlich langsamer verläuft als parallel dazu. Hierdurch läßt sich das Dickenwachstum der aus der Schmelze kritallisierenden Folie 24 gezielt aufbauen und steuern.

Durch das Fehlen von Kristallisationskeimen in der erfindungsgemäß eingesetzten Gleitschmelze wird ein grobkristallines vorzugsorientiertes Wachstum der Siliciumfolien mit Korngrößen weit größer als bei der direkten Gasphasen- oder Schmelzphasenbewachung fester Substrate gewährleistet. Als Materialien für den Impfbügel eignen sich solche, die möglichst ideal von Silicium benetzt werden. Dies ist naturgemäß bei einem Impfling aus Silicium der Fall. Günstig sind auch Impfbügel aus beispielsweise Graphit, welche es bei Schwierigkeiten zum Beginn des Kristallisationsprozeß, beispielsweise bei unvollständig angewachsenem Silicium, erlauben durch Wiedereintauchen in die Schmelze dieses rückzuschmelzen, ohne daß hierdurch die geometrische Form des Impfbügels verändert würde. Das Animpfen kann auf diese Art und Weise im Bedarfsfalle mehrfach hintereinander wiederholt werden, bis eine über die ganze Breite des Impfbügels gleichmäßig und in gewünschter Art und Weise angewachsene Siliciumfolie erhalten wird, die dann maßgeblich für deren Struktur ist.

Die an dem Impfbügel 23 ausgefrorene Siliciumfolie 24 wird anschließend über ein Kohlebrett 25, welches an seiner der Kühlrampe zugewandten Seite mit einem Abstreifer für die Gleitschmelze 7 versehen werden kann, in den über eine Schutzgaslanze 26 abgetrennten Austragsstutzen 27 abgezogen. Durch das Einblasen von Inertgas, wie beispielsweise Argon, über die Gaslanze 26 wird einerseits die Siliciumfolie 24 weiter abgekühlt, andererseits der Innenraum des Reaktors 1 gegen das Eindringen von Luft aus dem Austragsstutzen 27 geschützt. Über den Austragsstutzen 27 kann die Folie dann abschnittsweise oder kontinuierlich aus dem Rezipienten abgezogen werden.

Bei der diskontinuierlichen Arbeitsweise wird die Folie 24, wenn der den Impfbügel 23 haltende Wagen 22 die ganze Länge des Austragsstutzens 27 durchfahren hat, aus dem Reaktor entnommen, in der Art, daß beispielsweise durch Hochregeln des Heizers 19 die Kühlrampe 18 so weit aufgeheizt wird, daß kein weiteres Silicium am unteren Ende der erstarrenden Siliciumfolie 24 mehr anwächst.

Nach dem Entnehmen der Folie 24 wird der Wagen 22 mit einem neuen Impfbügel 23 wieder in den Rezipienten 1 eingefahren und der Kristallisationsprozeß von neuem begonnen. Bei der kontinuierlichen Arbeitsweise erfolgt der Weitertransport und die Förderung der Siliciumfolie 24 beispielsweise durch ein oberhalb und unterhalb der Folie 24 in oder außerhalb des Austragsstutzens 27 angebrachtes Walzenpaar.

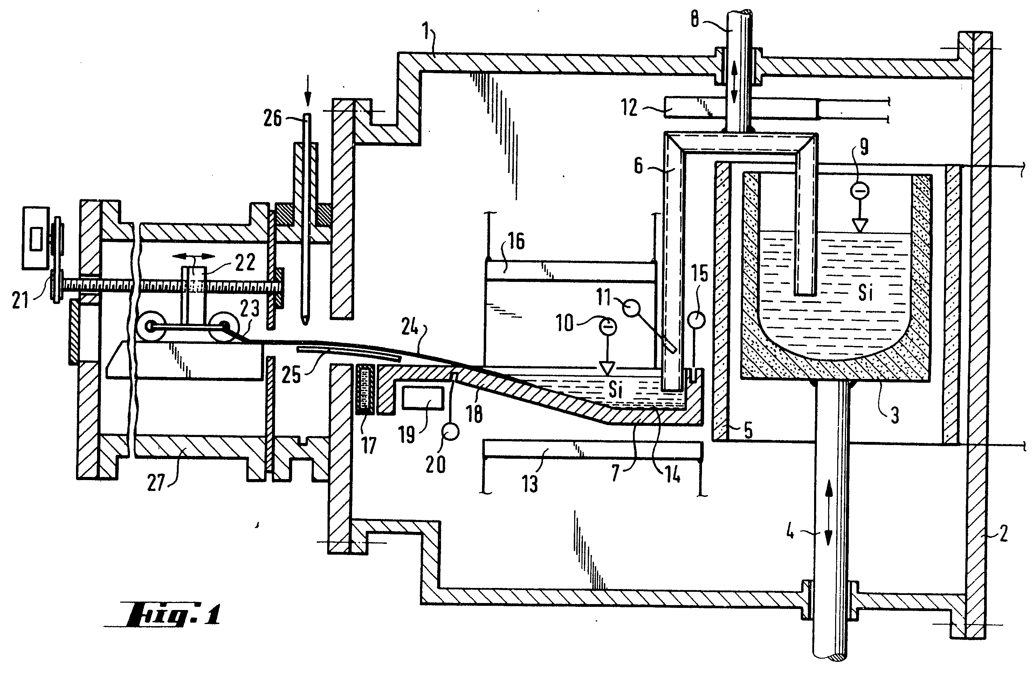

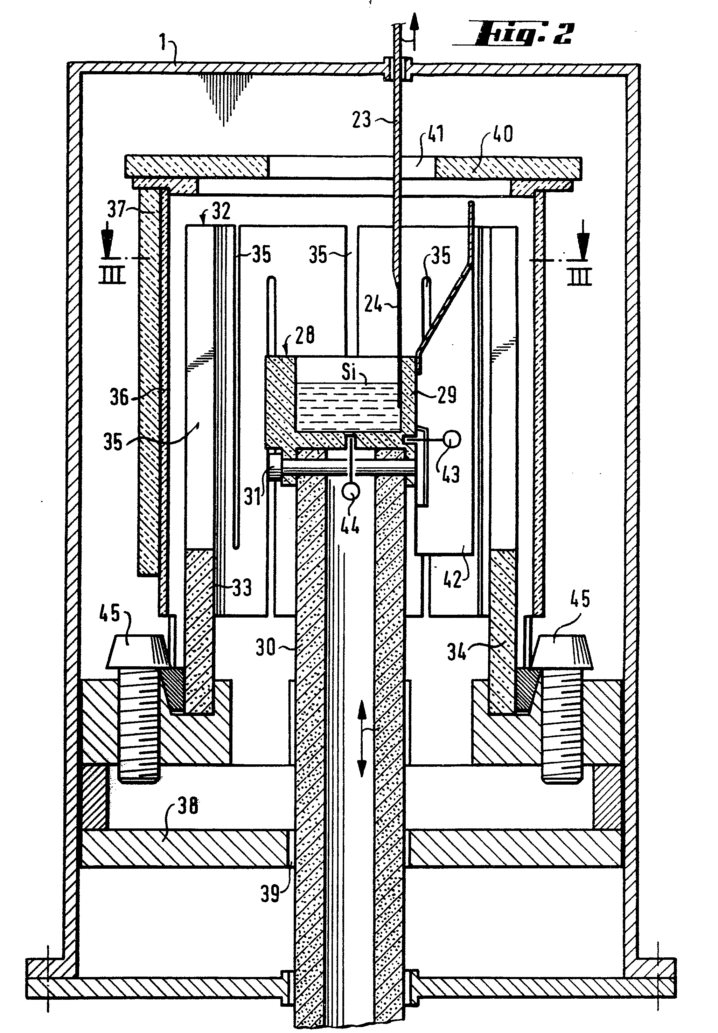

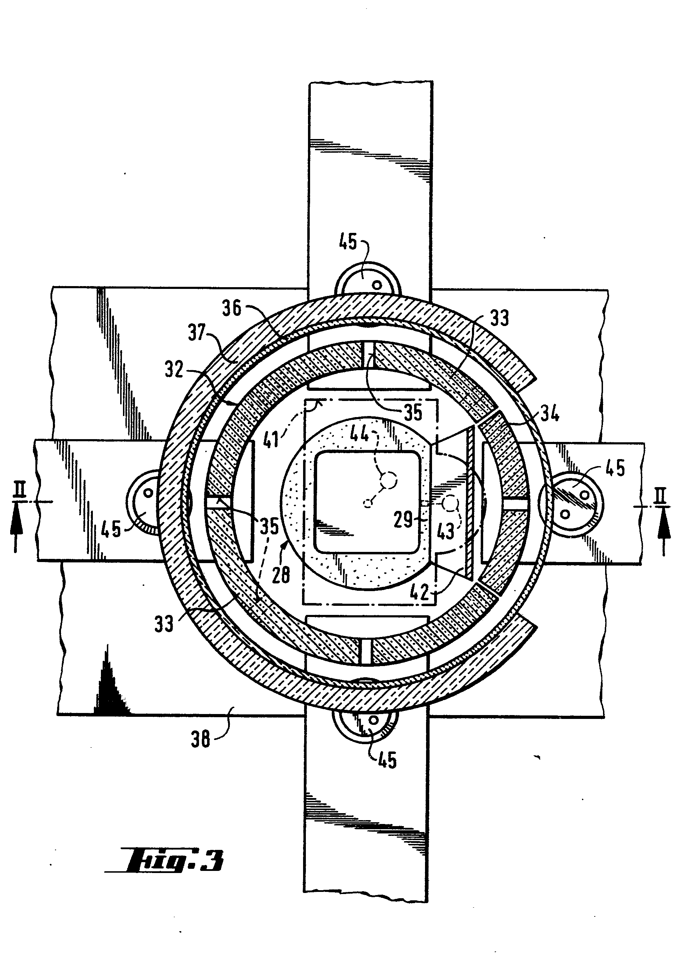

Die Steigung der Kühlrampe, die in der in Fig. 1 dargestellten Ausführungsform etwa 10° beträgt, kann prinzipiell zwischen +90 und -90° gegenüber der Horizontalen liegen. Im Falle von 0° wird der Siliciumfilm praktisch aus einem topfförmigen Kristallisationsgefäß über einen waagerechten Überlauf, der als Kühlrampe fungiert, abgezogen. Im Falle einer negativen Steigung wird aus einem derartigen Ziehgefäß überlaufendes Silicium längs einer nach unten geführten Kühlrampe abgezogen. Im Extremfall von -90° wird beispielsweise eine Kristallisationswanne bzw. ein Kristallisationsgefäß von quadratischem oder rechteckigem Querschnitt eingesetzt, dessen eine oder mehrere Seiten als Kühlrampen ausgebildet sind, über welche durch entsprechende Schlitze im Boden des Gefäßes die Siliciumfolie auf der Gleitschmelze gleitend nach unten abgezogen wird. Bevorzugt werden gemäß der Erfindung Steigungen der Kühlrampe gegenüber der Horizontalen von 0 bis +90°, wobei es platzmäßig meist günstiger noch ist, die Folie zur Seite unter einem Steigwinkel der Kühlrampe von etwa 5 bis 20° abzuziehen. In Abbildung 2 und 3 ist eine Versuchsanordnung für das senkrechte Abziehen im Längs- bzw. Querschnitt dargestellt. Das gezeigte Vorrichtungsdetail befindet sich dabei gleichermaßen in einem Rezipienten, wie er beispielsweise in Abbildung 1 dargestellt ist, nur mit dem Unterschied, daß der entsprechende Austragsstutzen nunmehr nicht seitlich, sondern senkrecht oberhalb des gezeigten Vorrichtungsdetails angebracht ist.

Bei dieser Verfahrensvariante sitzt ein Tiegel aus beispielsweise hochverdichtetem Graphit 28 mit nahezu quadratischer Querschnittsfläche, deren eine Seite 29 als Ziehrampe dient, auf einem Graphitstutzen 30 auf und wird über eine entsprechende Halterung 31 mit diesem fest verbunden. Der Graphitstutzen 30 verbindet den Tiegel 28 dabei mit einer wassergekühlten, vertikal beweglichen Tiegelwelle, wie sie in der Fig. 1 mit dem Hinweiszeichen 4 bezeichnet ist. Hierdurch wird eine Temperaturentkopplung zwischen Tiegel 28, welcher über die Tiegelheizung 32 beheizt wird und der zu ihrem eigenen Schutz wassergekühlten Tiegelwelle bewirkt. Der Tiegel 28 steht im Zentrum eines zylindrischen Widerstandsheizers, welcher aus zwei Teilheizungen, nämlich der eigentlichen Tiegelheizung 33 sowie der Rampenheizung 34, besteht, wie dies aus Abbildung 3 deutlich ersichtlich ist. Das Graphitrohr, aus welchem sich das Heizungssystem aufbaut, ist dabei mit mäanderförmig umlaufenden Schlitzen 35 versehen, durch welche ein bestimmter Strompfad und hierdurch ein für die Heizwirkung erforderlicher Widerstand vorgegeben wird. Dieses, sich aus den Teilheizungen 33 und 34 aufbauende, Heizungssystem 32 wird über vier Stromzuführungen 45 kontaktiert. Zur genauen Temperatureinstellung empfiehlt es sich außerdem, Tiegel und Heizanordnung mit einer zylinderförmigen oder mehrfachwandigen Abdeckung 36 aus beispilsweise Molybdänblech mit geeigneter Wärmeisolierung 37 aus beispielsweise Graphitfilz zu versehen. Die Bodenplatte 38 weist eine für den Durchtritt des auf der wassergekühlten Tiegelwelle aufseitzenden Graphitstutzens 30 erforderliche Öffnung 39 auf. In der abnehmbaren Deckplatte 40 befindet sich in der Mitte eine Öffnung 41, durch welche das an dem Impfkristallbügel 23 angewachsene Siliciumband 24 nach oben abgezogen werden kann und der geleerte Tiegel 28 ausgefahren und durch einen neu mit Silicium und Gleitschmelze befüllten Tiegel ersetzt werden kann.

Anstelle des Ersatzes eines geleerten Tiegels durch einen neu befüllten, wie es in der hier dargestellten Versuchsanlage erforderlich ist, läßt sich die Anordnung für die kontinuierliche Herstellung entsprechender Siliciumbänder auch dadurch erweitern, daß der Siliciumpegel durch Überlauf aus einem Vorratsgefäß nach Maßgabe des Verbrauchs auf konstanter Höhe gehalten wird. Ein Strahlblech 42 aus beispielsweise Molybdän dient zur thermischen Entkopplung von Tiegelheizung 33 und Rampenheizung 34. Hierdurch wird ein gezieltes Feinregeln der Temperatur an der Kühlrampe 29 durch die Rampenheizung 34 gewährleistet, welches andernfalls durch die Einstrahlung des großen Heizers 33 auf die Rampenheizung 34 nicht möglich wäre. Die unterschiedliche Einstellung von Tiegelheizung 33 und Rampenheizung 34 erlaubt die Temperatureinstellung an der Kühlrampe 29 wobei die Temperatur über die Thermoelemente 43 und 44 in der Schmelze sowie längs der Kristallisationsrampe 29 bestimmt wird.

Bei sämtlichen Verfahrensvarianten liegt die Unterkühlstrecke entlang der Kühlrampe, während welcher das Silicium längs der Oberfläche auf etwa 5 bis 100°, vorzugsweise etwa 10 bis 50°, unter seinen Schmelzpunkt abgekühlt und somit zum Erstarren gebracht wird, zwischen einigen Millimetern bis einigen Zentimetern. Abhängig von der Temperatur der Schmelze, der eingestellten Unterkühltemperatur sowie der Geschwindigkeit, mit der die Folien ausgetragen werden, muß die Unterkühlstrecke allgemein nur so lang sein, daß das Silicium an der Unterseite, d. h. an der Seite, die der Kühlrampe zugewandt ist, zusammenhängend erstarrt. Oberflächlich kann der ausgetragene Siliciumfilm durchaus noch von schmelzflüssigem Silicium überschichtet sein, welches dann im weiteren Verlauf des Austrages, nachkristallisiert. Entscheidend ist, daß die Siliciumfolie längs der Kühlstrecke zu einer selbsttragenden Dicke, also einer Foliendicke von mindestens etwa 0,1 mm erstarrt.

Wird eine Dotierung des Siliciumfilms erwünscht, so erfolgt diese zweckmäßig bei allen Ausführungsformen durch Zugabe von Dotierstoff zum flüssigen Silicium im Vorratsgefäß bzw. wenn ein solches nicht vorgesehen ist, direkt im Kristallisationsgefäß bzw. durch Vorlage bereits dotierten Siliciums. Eine andere Möglichkeit besteht noch darin, den Dotierstoff über die Gleitschmelze im Sinne des Verteilungsgleichgewichts flüssig/flüssig zuzuführen. Für den bevorzugten Einsatz der nach dem Verfahren hergestellten Siliciumfolien als Grundmaterial für Solarzellen ist eine Dotierung in einer Menge erforderlich, die zu einem spezifischen Widerstand von etwa 0,03 bis 3 Ω cm führt. Für eine p-Dotierung wird üblicherweise Aluminium, Gallium, Indium oder vorzugsweise Bor zugesetzt, für eine n-Dotierung Arsen, Antimon oder vorzugsweise Phosphor.

Der Kristallisationsprozeß als solcher kann unter Vakuum oder Schutzgas durchgeführt werden, bei der Verwendung eines geeigneten Gleitschmelzsystems kann allerdings auch unter Luftzutritt gearbeitet werden, wenn das Silicium allseitig von einem dünnen Gleitschmelzfilm überzogen ist.

Durch das erfindungsgemäße Verfahren wird ein Weg aufgezeigt, in rationeller Arbeitsweise billiges Solarzellengrundmaterial in großen Mengen herzustellen.


Beispiel 1

In einer Vorrichtung, wie sie in der Fig. 1 dargestellt ist, mit einer Kristallisationswanne aus Graphit mit einer Breite von 60 mm, einer Länge von 150 mm bei einer maximalen Tiefe von 50 mm wurden 400 g Silicium 60 g Gleitschmelze, bestehend aus Kalziumfluorid und Magnesiumsilikat zu gleichen Teilen, sowie 1 g Kalziumsulfat eingefüllt und aufgeschmolzen. Die in der Fig. 1 dargestellten Heizungen 16 und 13 wurden auf 27,5 kW hochgeregelt, die Rampenheizung, in der Fig. 1 mit dem Hinweiszeichen 19 bezeichnet, auf eine Leistung von 14 kW. Anschließend wurde ein Impfbügel aus Graphit 10 cm in die Kristallisationswanne eingeführt und der Heliumfluß im Kühlsystem 17 so eingestellt, daß die Rampentemperatur, gemessen mit dem Thermoelement 20 in Fig. 1, 1415°C betrug. Auch die Temperatur T2, gemessen mit dem Thermoelement 15, betrug zu diesem Zeitpunkt 1415°C, d. h. die Siliciumschmelze lag 5° unter dem Schmelzpunkt des Siliciums. Anschließend wurde die Rampenheizung 19 auf 3 kW zurückgenommen, während die Heizungen 16 und 13 auf 32,5 kW hochgeregelt werden mußten, um die während des ganzen Kristallziehens konstant zu haltende, am Thermoelement 15 gemessene Schmelzentemperatur von 1415°C zu gewährleisten. Nach der Zurückregelung der Rampenheizung wurde der in der Wanne eingeführte Impfbügel etwa eine Minute in der Position gehalten, um eine der Folienstärke entsprechende Anwachsung zu erzielen sowie die Einstellung eines stabilen Temperaturgleichgewichts zu gewährleisten. Anschließend wurde der Impfling mit der angewachsenen Siliciumfolie mit einer stetig auf die Endabziehgeschwindigkeit von 80 mm/Minute steigenden Anfahrgeschwindigkeit über die 150 mm lange, 50 mm breite mit 10° gegen die Horizontale ansteigende Rampe abgezogen.

Die Nachlieferung von Siliciumschmelze erfolgte aus einem Vorratsgefäß aus Quarz über einen u-förmigen Überlauf aus hochdichtem Graphit mit 0,2 cm breiten Rillen an der Außenseite.

Die dabei erhaltene Siliciumfolie wies die für die Herstellung einer Solarzelle günstige, grobkristalline Struktur auf und hatte eine Dicke von 0,8 ± 0,1 mm sowie eine Breite von 50 mm. Die Länge von 800 mm war durch die Abziehvorrichtung vorgegeben.

## Beispiel 2

In einer Vorrichtung, wie sie in den Fig. 2 und 3 dargestellt ist, wurde ein Tiegel aus hochdichtem Graphit mit einem Außendurchmesser von 100 mm und den Innenmaßen 60 × 60 mm² bei einer Tiefe von 35 mm mit 200 g Silicium und 20 g Gleitschmelze, bestehend 50 Gew.-% Kalziumfluorid und 50 Gew.-% Kalziumsilikat (CaF₂/CaSiO₃) befüllt und durch Einstellen der Tiegelheizung auf 32 kW und der Rampenheizung auf 14 kW aufgeschmolzen. Nach dem Aufschmelzen des Tiegelinhalts wurde auf ein automatische Regelsystem umgestellt. Hierbei wurde die Temperatur der Schmelze, gemessen mit einem Thermoelement in der Tiegelwand (vgl. Fig. 2 und 3, Hinweiszeichen 44) entsprechend einem vorgegebenen Sollwert von 1430°C durch Zurückfahren der Rampenheizung auf 12 kW und der Tiegelheizung auf 30 kW eingestellt. Nach Erreichen des Temperaturgleichgewichts wurden die Ansetzbedingungen für den Beginn des Folienziehens eingestellt. Hierzu wurde die Rampenheizung auf eine Leistung von 0 kW zurückgenommen, während die Tiegelheizung unverändert bei einer Leistung von 30 kW belassen wurde. Die Temperatur in der Schmelze ging dabei zurück auf 1415°C, während mit dem Thermoelement in der Kühlrampe (Hinweiszeichen 43 in Fig. 2 und 3) eine Temperatur von 1365° anzeigte. Anschließend wurde ein Impfling direkt an der Rampe entlang 5 mm unter den Spiegel der Siliciumschmelze eingetaucht und sofort mit langsam steigender Geschwindigkeit mit der angewachsenen Silisiumfolie senkrecht nach oben abgezogen. Als Impfling wurde dabei ein Siliciumbrett von 50 mm Breite und 3 mm Dicke eingesetzt, das an einer Graphithalterung befestigt war.

Abhängig von der Dimension des Austragsstutzens wurde bei diesem dikontinuierlichen Prozeß ein 50 cm langes Band mit etwa 50 mm Breite und grobkristalliner Struktur gezogen. Bei diesem Versuch wurde die Abhängigkeit der Dicke von der Ziehgeschwindigkeit bestimmt. Die ersten 10 Zentimeter des Bandes wurden mit einer Geschwindigkeit von 5 mm/Minute gezogen und wiesen eine Dicke von 1,8 mm auf. Die weiteren 10 Zentimeter mit 10 mm/Minute ergaben eine Dicke von 1,2 mm. Weitere 10 Zentimeter mit 20 mm/Minute eine solche von 0,8 mm, während der Rest mit einer gleichbleibenden Geschwindigkeit von 40 mm/Minute gezogen wurde, woraus ein Siliciumband mit einer Dicke von 0,6 mm resultierte. Die in dieser kleinen Versuchsanlage erzielten Ziehgeschwindigkeiten lassen beim Übergang in Produktionsanlagen mit entsprechend großen, exakt temperierbaren und nachchargierbaren Siliciumschmelzen Ziehgeschwindigkeiten erwarten, die um ein vielfaches über denen der kleinen Versuchsanlage liegen, da bei Großanlagen die Temperaturverhältnisse durch das Abziehen von Siliciumfolie kaum beeinflußt werden.

## Patentansprüche

1. Verfahren zur Herstellung grobkristalliner vorzugsorientierter Siliciumfolien mit einer Dicke von 0,2 bis 2 mm als Grundmaterial für Solarzellen durch in Kontakt bringen einer Siliciumschmelze mit einer schmelzflüssigen, mit Silicium nicht mischbaren, niedriger schmelzenden, nicht elementaren Zweitphase und nachfolgendem Erstarrenlassen, dadurch gekennzeichnet, daß aus einem flüssiges Silicium und eine Silicium benetzende Gleitschmelze enthaltendem Ziehgefäß durch Unterkühlung mindestens einer über die Schmelzoberfläche herausragenden, eine Ziehrampe bildenden Gefäßwandung auf 1320 bis 1415°C ein auf dieser Fläche auskristallisierender Siliciumfilm kontinuierlich abgezogen wird.

2. Verfahren nach Anspruch 1, dadurch gekennzeichnet, daß der Schmelzpegel im Ziehgefäß durch Zufluß an flüssigem Silicium aus einem Vorratsgefäß geregelt wird.

3. Verfahren nach Anspruch 1 oder 2, dadurch gekennzeichnet, daß an einer vertikal ansteigenden Wandung des Ziehgefäßes ein Siliciumfilm kontinuierlich nach oben abgezogen wird.

4. Verfahren nach einem oder mehreren der Ansprüche 1 bis 3, dadurch gekennzeichnet, daß die Grenzflächenspannung zwischen Silicium und Gleitschmelze durch geeignete Zusätze in der Gleitschmelze herabgesetzt wird.

5. Verfahren nach Anspruch 4, dadurch gekennzeichnet, daß die Grenzflächenspannung zwischen Silicium und Gleitschmelze durch sulfidische Zusätze in der Gleitschmelze herabgesetzt wird.

6. Verfahren nach einem oder mehreren der Ansprüche 1 bis 5, dadurch gekennzeichnet, daß als Gleitschmelze eine Schmelze aus Erdalkalifluoriden im Gemisch mit 10 bis 90 Mol.-% Erdalkalisilikaten mit einem Schmelzpunkt unterhalb dem des Siliciums eingesetzt wird.

## Claims

1. Process for the manufacture of granular crystalline silicon sheets of preferred orientation, having a thickness of between 0.2 and 2 mm, as base material for solar cells by bringing a silicon melt into contact with a second molten non-elemental phase which is immiscible with silicon and has a melting point below that of silicon and subsequently allowing the silicon to solidify, characterized in that by supercooling to 1320 to 1415°C at least one wall of a pulling vessel, protruding over the melting surface and thus forming a pulling ramp, a silicon film crystallizing out on said surface is continuously drawn off from said pulling vessel containing liquid silicon and a lubricating melt wetting silicon.

2. Process according to claim 1, characterized in that the level of melt in the pulling vessel is controlled by the inflow of molten silicon from a supply vessel.

3. Process according to claim 1 or 2, characterized in that a silicon film is continuously drawn off in the direction of the top from a vertically rising wall of the pulling vessel.

4. Process according to one or more of claims 1 to 3, characterized in that the interfacial tension between the silicon and the lubricating melt is reduced by suitable additives in the lubricating melt.

5. Process according to claim 4, characterized in that the interfacial tension between the silicon and the lubricating melt is reduced by sulphidic additives in the lubricating melt.

6. Process according to one or more of claims 1 to 5, characterized in that a melt that consists of alkaline earth metal fluorides in admixture with 10 to 90 mole % of alkaline earth metal silicates and has a melting point below that of silicon is used as the lubricating melt.

## Revendications

1. Procédé de production de feuilles de silicium en gros cristaux à orientation préférentielle, présentant une épaisseur de 0,2 à 2 mm, destinées à servir de matières de base pour des piles solaires, par mise en contact d'une masse de silicium fondue avec une seconde phase non élémentaire, fondue, non miscible avec le silicium et à plus bas point de fusion que celui-ci, puis en laissant solidifier, procédé caractérisé en ce qu'on tire continuellement d'un récipient contenant du silicium liquide et une masse de lubrifiant pouvant mouiller le silicium, en refroidissant à 1320° à 1415°C au moins une paroi du récipient formant une rampe de traction faisant saillie au-dessus de la surface de la masse fondue, un film de silicium qui cristallise sur cette surface de rampe.

2. Procédé selon la revendication 1, caractérisé en ce que le niveau de la masse fondue présente dans le récipient est réglé par addition de silicium liquide provenant d'un réservoir.

3. Procédé selon l'une des revendications 1 et 2, caractérisé en ce qu'un film de silicium est tiré continuellement vers le haut le long d'une paroi verticalement ascendante du récipient.

4. Procédé selon l'une quelconque des revendications 1 à 3, caractérisé en ce que la tension superficielle à la surface de séparation du silicium de la masse de lubrifiant fondue est abaissée par des additifs convenables introduits dans la masse de lubrifiant fondue.

5. Procédé selon la revendication 4, caractérisé en ce que la tension superficielle à la surface de séparation entre le silicium et la masse de lubrifiant fondue est abaissée par des additions de sulfure à la masse de lubrifiant fondue.

6. Procédé selon l'une quelconque des revendications 1 à 5, caractérisé en ce qu'on utilise comme masse de lubrifiant fondue une masse fondue, présentant un point de fusion inférieur à celui du silicium et constituée par des fluorures alcalinoterreux en mélange avec 10 à 90 moles % de silicates alcalino-terreux.

**Fig. 1**

0 013 985

**Fig: 2**

**Fig. 3**